# EUROPÄISCHE PATENTSCHRIFT

(11) **EP 0 967 657 B1**
(45) Veröffentlichungstag und Bekanntmachung des Hinweises auf die Patenterteilung: **06.01.2010**
(21) Anmeldenummer: 99112269.8
(22) Anmeldetag: 25.06.1999
(51) Int. Cl.: H01L 29/06, H01L 29/78

(54) **NMOS-Transistor**
NMOS-Transistor
Transistor NMOS

(30) Priorität: 26.06.1998 DE 19828524; 03.09.1998 DE 19840180
(43) Veröffentlichungstag der Anmeldung: 29.12.1999
(73) Patentinhaber: ELMOS Semiconductor AG, 44227 Dortmund (DE)
(72) Erfinder: Gehrmann, Andreas, 44287 Dortmund (DE); Müsch, Erhard, 59368 Werne (DE)
(74) Vertreter: Hilleringmann, Jochen

(56) Entgegenhaltungen:
- JP-A- 9 181 302
- JP-A- 10 116 921
- US-A- 5 208 171
- US-A- 5 268 312
- US-A- 5 455 437
- US-A- 5 698 458

## Beschreibung

Die Erfindung betrifft einen NMOS-Transistor nach dem Oberbegriff des Anspruchs 1, wie aus US-A-5,698,458 grundsätzlich bekannt.

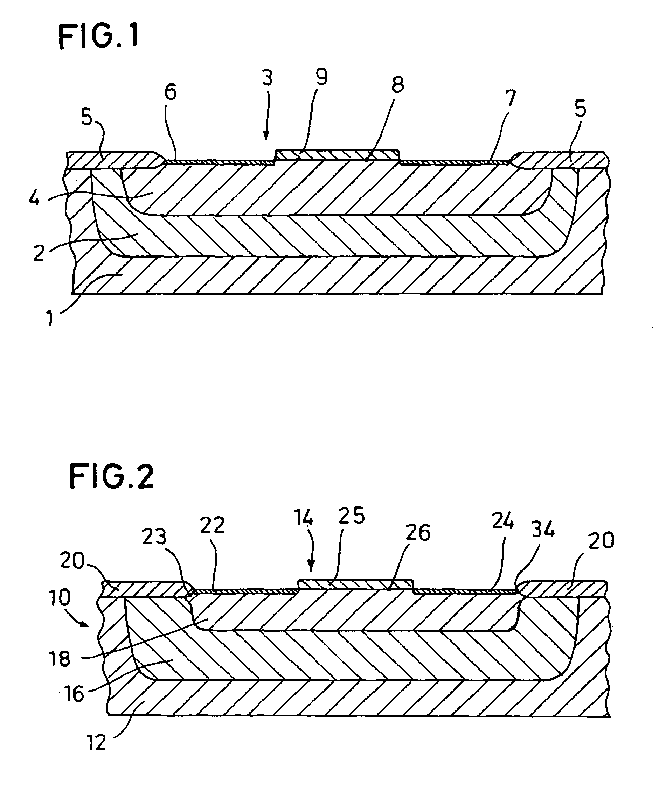

Um eine weitestgehend störungsfreie Funktion eines NMOS-Transistors auch bei Betriebsspannungen, die kleiner als das Substratpotential sind, garantieren zu können, bedient man sich einer Well-in-Well Technologie, bei der in einem CMOS-Prozess innerhalb eines ersten n-leitenden Gebiets, nämlich einer n-Wanne, ein zweites p-leitendes Gebiet in Form einer p-Wanne eingebracht wird. Ein solcher Transistor ist in Fig. 1 im Schnitt dargestellt. Der Transistor weist ein schwach p-dotiertes halbleitendes Substrat 1 auf, in das mittels Diffusion eine n-Wanne 2 eingebracht ist. Innerhalb dieses n-leitenden Gebiets ist von der Oberseite 3 des Substrats 1 aus ein p-leitendes Gebiet, nämlich eine p-Wanne 4 mittels Diffusion eingebracht. Das p-leitende Gebiet 4 ist an der Oberseite 3 des Substrats 1 durch eine Feldoxidschicht 5 allseitig begrenzt, wobei sich die p-Wanne mit ihrem Begrenzungsrand zur n-Wanne 2 wegen der "Unterdiffusion" unterhalb der Feldoxidschicht 5 befindet. In die p-Wanne 4 sind entartete n⁺ Gebiete 6 und 7 für Source und Drain eingebracht, zwischen denen sich die Gateoxidschicht 8 und die Gateelektrode 9 befindet. Aus US-A-5,698,458 ist es darüber hinaus bekannt, das p-leitende Gebiet mittels einer die Feldoxidschicht längs der Aktivgebietskante durchdringenden Ionenimplantation zu erzeugen, wobei sich bei dieser Ionenimplantation unterhalb des Feldoxids p-dotierte Zonen bilden, die den durch "Unterdiffusion" entstehenden Zonen gleichen.

Durch eine derartige NMOS-Transistor-Konstruktion erreicht man:
- eine elektrische Isolation des NMOS-Transistors vom Substrat durch zwei pn-Übergänge,
- eine Vermeidung des Substrateffektes durch die Möglichkeit, das Potential der p-Wanne auf das Sourcepotential des Transistors zu legen und
- einen Betrieb der p-Wanne und des Transistors unter Substratpotential.

Für die obige Transistor-Konstruktion sind jedoch entsprechend geeignete Wannen erforderlich, wobei die n-Wanne deutlich tiefer als die p-Wanne sein muss, um die geforderten Isolationseigenschaften und Spannungsfestigkeiten zu gewährleisten. Bei Nutzung der üblichen diffundieren Wannen bedeutet dies einen erheblichen Prozessaufwand:
- Bei einem vorhandenen n-Wannen CMOS-Prozess ist die Einführung einer zusätzlichen p-Wanne mit kompletter Änderung des Prozessanfangs (WannendiNusion/Feldoxidation/Temperaturhaushalt) erforderlich;
- Bei Nutzung von Epi-Substraten ist die Eindringtiefe der n-Wanne durch die Ausdiffusion der Substratdotierung limitiert;
- Bei einer diffundierten p-Wanne ist die Oberflächenkonzentration (Schwellenspannung des NMOS-Transistors) und das Dotierungsprofil in der Tiefe (Isolation/Spannungsfestigkeit des NMOS-Transistors zur n-Wanne) miteinander verkoppelt;
- Eine Anpassung der Wannendötierungen/-diffusionen bedeutet gleichzeitig einen Einfluss auf fast alle anderen Bauelemente.

Der Erfindung liegt die Aufgabe zugrunde, einen Well-in-Well NMOS-Transistor zu schaffen, der unter Ausnutzung der Prozessschritte eines n-Wannen-CMOS-Prozesses herstellbar ist.

Zur Lösung dieser Aufgabe wird für einen NMÖS-Transistor nach dem Oberbegriff des Anspruchs 1 vorgeschlagen, dass das p-leitende Gebiet (18) zwischen der Oberseite (14) des Substrats (12) und seiner innerhalb des Subrats (12) angeordneten unteren Grenze zum n-leitenden Gebiet (16) allseitig eine Lateralbegrenzung aufweist, die mit der Aktivgebietskante (34) fluchtet (Selbstjustage).

Bei dem erfindungsgemäßen NMOS-Transistor wird also die p-Wanne (p-leitenden Gebiet bzw. eigentliches Substratgebiet, in dem der Transistor ausgebildet ist) durch Ionenimplantationen erzeugt. Diese Implantation erfolgt in zwei Schritten, wobei die Konzentration in der Tiefe der p-Wanne, also an deren unteren Grenze zur n-Wanne größer ist als an der Oberfläche der p-Wanne, wo sie durch die gewünschte Schwellenspannung bestimmt ist.

Durch dieses retrograde p-Dotierstoff-Konzentrationsprofil der p-Wanne ist es möglich, die p-Wanne relativ flach auszubilden, ohne daß die Gefahr eines "Punch-through"-Effekts zwischen den entarteten n⁺ Gebieten für Drain bzw. Source und der n-Wanne besteht.

Zur Erhöhung der Ausgangsspannungsfestigkeit U_{DS} des NMOS-Transistors ist es zweckmäßig, die Source- und Draingebiete lateral zum Feldoxid zu beabstanden. Zur Unterdrückung des parasitären NMOS-Transistors, der von dem Source- oder Draingebiet, der Gateelektroden-Anschlußbahn und dem n-leitenden Gebiet gebildet ist, ist es von Vorteil, wenn die Oberseite des Substrats im an das Feldoxid angrenzenden Randbereich des p-leitenden Gebiets zumindest unterhalb einer Gateelektroden-Anschlußbahn mittels p-dotierender Ionenimplantation eine erhöhte Ionenkonzentration aufweist.

Für die Realisierung des erfindungsgemäßen NMOS-Transistors wurde ein neuer Ansatz gewählt, nämlich
- die Beibehaltung des bisherigen Wannenkonzeptes (diffundierte n-Wanne) und
- die Erzeugung der p-Wanne durch eine (vorhandene) Implantation,
- wobei keine Änderung des thermischen Haushaltes (Kompatibilität, modulare Prozeßoption) erfolgt.

Nachfolgend werden anhand der Zeichnung Ausführungsbeispiele der Erfindung näher erläutert. Im einzelnen zeigen:
- Fig. 1: einen Schnitt durch einen bekannten Well-in-Well NMOS-Transistor, dessen Wannen durch Diffusion erzeugt sind,
- Fig. 2: einen Schnitt durch einen NMOS-Transistor gemäß einem ersten Ausführungsbeispiel,
- Fig. 3: einen Schnitt durch einen NMOS-Transistor gemäß einem zweiten Ausführungsbeispiel,
- Fig. 4: einen Schnitt durch einen NMOS-Transistor gemäß einem dritten Ausführungsbeispiel und
- Fig. 5: einen quer zu den Schnittansichten der Fign. 2 und 3 verlaufenden Schnitt durch einen NMOS-Transistor gemäß einem vierten Ausführungsbeispiel.

Der NMOS-Transistor 10 gemäß Fig. 2 weist ein schwach p-dotiertes Substrat 12 auf, in das von der Oberseite 14 her eine n-Wanne 16 eindiffundiert ist. Innerhalb dieser n-Wanne 16 befindet sich eine durch Doppelimplantation erzeugte p-Wanne 18, die das eigentliche Substratgebiet des NMOS-Transistors 10 bildet. Um die p-Wanne 18 herum ist auf der Oberseite 14 eine durch einen LOCOS-Prozeß aufgebrachte Feldoxidschicht 20 angeordnet. Innerhalb der p-Wanne 18 befinden sich an der Oberseite des Substrats 12 die n⁺ Gebiete 22,24 für Source und Drain sowie die dazwischenliegende Gateoxidschicht 26 und die Gateelektrode 25.

Die schwach dotierte p-Wanne 18 wird durch eine Bor-Implantation innerhalb der n-Wanne 16 erzeugt. Für diese p-Wanne 18 ergeben sich folgende Anforderungen:
- geringe Oberflächenkonzentration zur Einstellung der Schwellenspannung des NMOS-Transistors 10
- max. Tiefe von ca. 1.5 µm (vorgegeben durch n-Wanne 16)
- Ausreichende Dotierungskonzentration in der Tiefe, um die Isolation des Transistors 10 zur n-Wanne 16 sicherzustellen.

Insbesondere bei einem 1,2 µm bzw. 1,6 µm n-Wannen-CMOS-LOCOS-Prozeß werden diese Forderungen durch eine zweigeteilte Implantation (PDEX-Implantation) erreicht, die nach einem Fotolithographieschritt vor der Polyabscheidung erfolgt. Durch diese Implantation kann in der Tiefe ein nahezu beliebiges retrogrades Wannenprofil mit den gewünschten Eigenschaften bezüglich Spannungsfestigkeit eingestellt werden. Die Oberflächendotierung, und damit die Schwellenspannung des Transistors 10, kann unabhängig davon durch eine normale Schwellenspannungsimplantation eingestellt werden.

Wird die Energie der p-Wannenimplantation derart gewählt, das die Implantation nur im Aktivgebiet, nicht aber durch die Feldoxidschicht 20 erfolgt, erreicht man eine Selbstjustage der p-Wanne 18 zur Aktivgebietskante 34. Zusammen mit der geringen Ausdiffusion der implantierten p-Wanne 18 erlaubt dies im Vergleich zu diffundierten p-Wannen eine höhere Packungsdichte in Logikanwendungen. Die laterale Isolation 23 erfolgt hierbei durch das Durchimplantieren des Bird's-Beak an den Aktivgebietsrändern, die relativ große laterale Streuung der hochenergetischen p-Wannenimplantation sowie der höheren Ausdiffusion der Bor-Implantation verglichen mit der Arsen-Implantation der Drain- und Sourcegebiete 22,24.

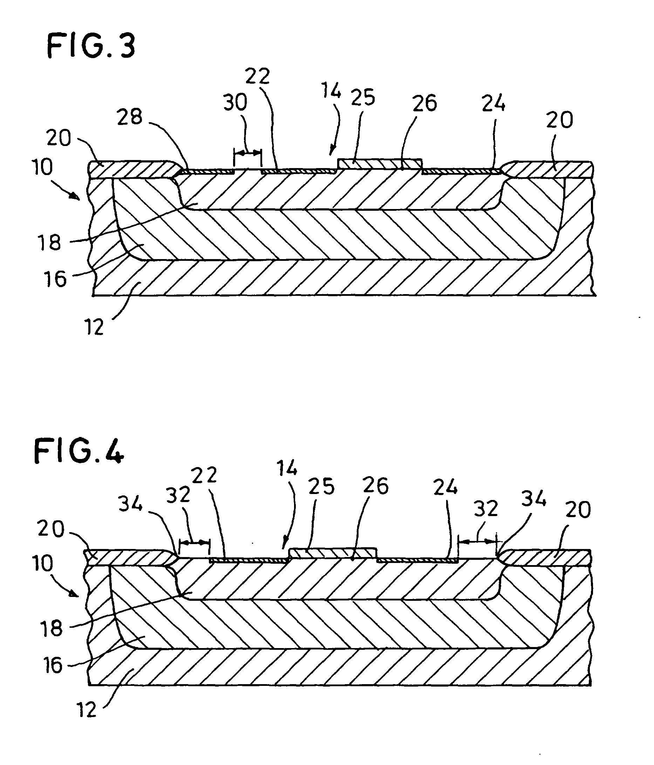

Die Kontaktierung 28 der p-Wanne 18 muß in diesem Fall innerhalb des gleichen Aktivgebietes erfolgen (s. Fig. 3). Als Kontaktimplantation dient hierzu die Drain/Source-Implantation der mit dem verwendeten CMOS-Prozeß herstellbaren PMOS-Transistoren. Liegt das p-Wannenpotential unter dem Source-Potential des NMOS-Transistors 10, sollte auf einen ausreichenden Abstand 30 zwischen der p+ Kontaktierung 28 und dem Source- oder Draingebiet 22,24 geachtet werden.

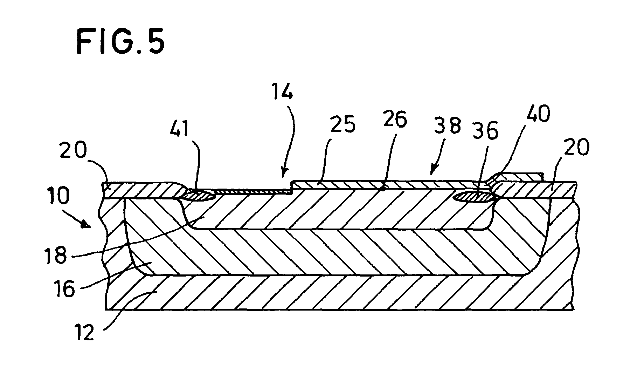

Bezüglich der geforderten Spannungsfestigkeit des NMOS-Transistors zur n-Wanne 16 stellt die laterale Isolation (Abstand 23) besonders bei den für Analoganwendungen geforderten höheren Spannungen einen kritischen Punkt dar. Eine Erhöhung der Spannungsfestigkeit läßt sich durch die Einführung eines mit Hilfe einer Lackmaske erzeugten Abstandes 32 zwischen den Source- bzw. Draingebieten 22,24 und dem Aktivgebietsrand 34 erzielen (s. Fig. 4). Durch eine weitere im Prozeß vorhandene Bor-Implantation bei 41 läßt sich die Dotierung der p-Wanne 18 im kritischen Bereich weiter anheben und ein Punch-through-Effekt zwischen dem Source-Gebiet 14 und der n-Wanne 16 verhindern. Gleichzeitig erzielt man durch diese Implantation eine Erhöhung der Schwellenspannung 36 (siehe in Fig. 5) bei dem parasitären NMOS-Transistor 38, der sich unter einer Polybahn (Anschlußbahn 40 für die Gateelektrode) zwischen Drain oder Source des eigentlichen Transistors 10 und der n-Wanne 16 bildet (s. Fig. 5).

Der so aufgebaute Transistor erfüllt sämtliche der nachfolgend genannten Anforderungen bei vollständiger Kompatibilität zum vorhandenen CMOS-Prozeß:
1. Isolation vom p-Substrat und damit Entkopplung von Einflüssen durch Bulk-Noise und Substratströmen
2. Kein Substrateffekt
3. Betrieb des NMOS-Transistors bei Spannungen kleiner Vss (Substratpotential)
4. Eignung für den Aufbau einer komplett in der n-Wanne liegenden CMOS-Logik
5. Spannungsfestigkeit von 5 V für Digitalanwendungen bis max. 10 V für Analoganwendungen
6. Hohe Packungsdichte für Logikanwendung
7. Möglichst geringe und vor allem modulare Prozeßaufweitung
8. Kein Einfluß der Prozeßaufweitung auf das Verhalten der anderen Bauelemente

Einzige Prozeßerweiterung ist die p-Wannenimplantation (PDEX-Implantation), die jedoch für andere Herstellungsschritte im LOCOS-Prozeß verwendet wird, also keinen zusätzlichen neuen Technologieprozeßschritt darstellt.

## Patentansprüche

1. NMOS-Transistor mit
- einem halbleitenden Substrat (12), das p-dotiert ist und eine Oberseite (14) aufweist,
- einem ersten Gebiet (16), das n-dotiert ist und durch Diffusion von der Oberseite (14) des Substrats (12) in dieses eingebracht ist,
- einem innerhalb des n-leitenden Gebiets (16) angeordneten zweiten Gebiet (18), das p-dotiert und von der Oberseite (14) des Substrats (12) in dieses eingebracht ist, wobei das p-leitende Gebiet (18) mittels einer Ionenimplantation in das n-leitende Gebiet (16) eingebracht ist und innerhalb des p-leitenden Gebiets (18) die Ionenkonzentration an der Oberseite (14) des Substrats (12) kleiner ist als an der innerhalb des Substrats (12) angeordneten unteren Grenze des n-leitenden Gebiets (16) zum p-leitenden Gebiet (18),
- einer Feldoxidschicht (20), die auf der Oberseite (14) des Substrats (12) angeordnet ist und eine das p-leitende Gebiet (16) allseitig begrenzende Aktivgebietskante (34) bildet,
- einem Sourcegebiet (22) sowie einem Draingebiet (24), die n-dotiert sind und voneinander beabstandet innerhalb des p-leitenden Gebiets (18) in der Oberseite (14) des Substrats (12) angeordnet sind,
- einer Gateoxidschicht (26), die auf der Oberseite (14) des Substrats (12) zwischen dem Source- und dem Draingebiet (22,24) angeordnet ist, und
- einer Gateelektrode (25) auf der Gateoxidschicht (26),
**dadurch gekennzeichnet,**
- **dass** das p-leitende Gebiet (18) zwischen der Oberseite (14) des Substrats (12) und seiner innerhalb des Subrats (12) angeordneten unteren Grenze zum n-leitenden Gebiet (16) allseitig eine Lateralbegrenzung aufweist, die durch die Aktivgebietskante (34) definiert ist.

2. NMOS-Transistor nach Anspruch 1, **dadurch gekennzeichnet, dass** das Source- und das Draingebiet (22,24) lateral zum Feldoxid (20) beabstandet (32) sind.

3. NMOS-Transistor nach Anspruch 1 oder 2, **dadurch gekennzeichnet, dass** die Oberseite (14) des Substrats (12) im an das Feldoxid (20) angrenzenden Randbereich des p-leitenden Gebiets (18) zumindest unterhalb einer Gateelektroden-Anschlussbahn (40) mittels p-dotierender Ionenimplantation eine erhöhte Ionenkonzentration zur Unterdrückung eines parasitären NMOS-Transistors (38) aufweist, der von dem Source- oder Draingebiet (22,24), der Gateelektroden-Anschlussbahn (40) und dem n-leitenden Gebiet (16) gebildet ist.

## Claims

1. An NMOS transistor comprising
- a semiconducting substrate (12) which is p-doped and comprises a top side (14),
- a first region (16) which is n-doped and placed into the substrate by diffusion from the top side (14) of the substrate (12),
- a second region (18) arranged within the n-conducting region (16), which is p-doped and placed into the substrate from the top side (14), the p-conducting region (18) being placed by means of an ion implantation into the n-conducting region (16), and within the p-conducting region (18)the ion concentration on the top side (14) of the substrate (12) is smaller than that at the lower limit, located within the substrate (12), between the n-conducting region (16) and the p-conducting region (18),
- a field oxide layer (20) arranged on the top side (14) of the substrate (12) and forming an active region edge (34) limiting the p-conducting region (16) on all sides,
- a source region (22) as well as a drain region (24) which are n-doped and arranged at a distance from each other within the p-conducting region (18) on the top side (14) of the substrate (12),
- a gate oxide layer (26) arranged on the top side (14) of the substrate (12) between the source and the drain regions (22, 24), and
- a gate electrode (25) on the gate oxide layer (26),
**characterized in that**
- between the top side (14) of the substrate (12) and its lower limit with the n-conduction region (16), located in within the substrate (12), the p-conducting region (18) comprises a lateral border on all sides that is defined by said active region edge (34).

2. The NMOS transistor according to claim 1, wherein the source and the drain region (22, 24) are arranged at a lateral distance (32) to the field oxide (20).

3. The NMOS transistor according to claim 1 or 2, wherein the top side (14) of the substrate (12) comprises in the marginal region, adjacent to the field oxide (20), of the p-conducting region (18) at least beneath a gate electrode connecting trace (40) an ion concentration increased by means of p-doping ion implantation to suppress a parasitic NMOS transistor (38) formed by the source or the drain region (22, 24), the gate electrode connecting trace (40) and the n-conducting region (16).

## Revendications

1. Transistor NMOS comprenant
- un substrat semiconducteur (12) dopé en p et comprenant une face supérieure (14),
- une première région (16) dotée en n et introduite dans la face supérieure (14) du substrat (12) par diffusion à partir de ladite face,
- une deuxième région (18) dotée en p et introduite dans la face supérieure (14) du substrat (12) à partir de ladite face, la deuxième région étant prévue dans la première région (16) conductrice type n, la région conductrice type p (18) étant introduite dans la région conductrice type n (16) par implantation ionique, et la concentration d'ions à la face supérieure (14) du substrat (12) est inférieure à la concentration à la limite basse de la région conductrice type n (16) avec la région conductrice type p (18), située au sein du substrat (12),
- une couche d'oxyde de champ (20), disposée sur la face supérieure (14) du substrat (12) et formant un bord de la région active (34) limitant la région conductrice type p (16) partout,
- une région de source (22) et une région de drain (24), dotées en n et écartées l'une de l'autre au sein de la région conductrice p (18) dans la face supérieure (14) du substrat (12),
- une couche d'oxyde de grille (26) disposée sur la face supérieure (14) du substrat (12) entre la région de source et la région de drain (22, 24), et
- une électrode de grille (25) sur la couche d'oxyde de grille (26),
**caractérisé en ce que**
- entre la face supérieure (14) du substrat (12) et sa limite basse avec la région conductrice type n (16), disposée au sein du substrat (12), la région conductrice type p (18) comprend une limite latérale sur tous côtés qui est définie par le bord de la région active (34).

2. Transistor NMOS selon la revendication 1, **caractérisé en ce que** la région de source et de drain (22, 24) sont écartées latéralement (32) de l'oxyde de champ (20).

3. Transistor NMOS selon la revendication 1 ou 2, **caractérisé en ce que** la face supérieure (14) du substrat (12) comprend, dans la zone marginale de la région conductrice type p (18) près de l'oxyde de champ (20), au moins dessous une piste de connexion de l'électrode de grille (40), une concentration d'ions augmentée par implantation ionique dotant en p pour supprimer un transistor NMOS parasitaire (38) formé par la région de source ou de drain (22, 24), la piste de connexion de l'électrode de grille (40) et la région conductrice type n (16).
